(19) Europäisches Patentamt
European Patent Office
Office européen des brevets

(11) **EP 4 354 224 A1**

(12) **EUROPEAN PATENT APPLICATION**

(43) Date of publication:
**17.04.2024 Bulletin 2024/16**

(21) Application number: **22200780.9**

(22) Date of filing: **11.10.2022**

(51) International Patent Classification (IPC):
*G03F 7/20* *(2006.01)* *H04N 25/443* *(2023.01)*

(52) Cooperative Patent Classification (CPC):
**G03F 7/7085; H04N 25/40; H04N 25/443**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventors:
• **VAN DER POST, Sietse, Thijmen**
**5500 AH Veldhoven (NL)**
• **SCHERJON, Martinus Paulus, Maria**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD FOR OPERATING A DETECTION SYSTEM OF A METROLOGY DEVICE AND ASSOCIATED METROLOGY DEVICE**

(57) Disclosed is a method of reading out a detection arrangement, said detection arrangement defining a detection area in terms of plurality of pixels. The method comprises receiving scattered radiation on said detection arrangement; dividing the detection area into at least two different regions of interest based at least on a measurement parameter of said scattered radiation; and employing a respective different readout scheme for each said regions of interest, so as to read out said detection arrangement.

(a)    (b)

Fig. 10

EP 4 354 224 A1

**Description**

FIELD

The present invention relates to metrology applications in the manufacture of integrated circuits.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the measurement radiation used during metrology (e.g. moving towards the "soft X-ray (SXR)" wavelength spectrum), it is possible to resolve smaller structures, to increase sensitivity to structural variations of the structures and/or penetrate further into the product structures. One such method of generating suitably high frequency measurement radiation (e.g., hard Xray, soft X-ray and/or EUV radiation) may be using a pump radiation (e.g., infrared IR radiation) to excite a generating medium, thereby generating an emitted radiation, optionally a high harmonic generation comprising high frequency radiation.

In some metrology systems, e.g. soft X-ray SXR metrology systems, a pixelated detector is used to measure diffracted light from a sample. The illumination beam may have relatively low divergence giving rise to diffraction orders that are detected on only a few pixels of the detector.

It would be desirable to optimize readout of such a detector.

SUMMARY

In a first aspect of the invention there is provided a method of reading out a detection arrangement, said detection arrangement defining a detection area in terms of plurality of pixels, the method comprising: receiving scattered radiation on said detection arrangement; dividing said detection area into at least two different regions of interest based at least on a measurement parameter of said scattered radiation; and employing a respective different readout scheme for each said regions of interest, so as to read out said detection arrangement.

In a second aspect of the invention there is provided a detection module, comprising: a detection arrangement defining a detection area in terms of plurality of pixels; and a processor operable to: divide said detection area into at least two different regions of interest based at least on a measurement parameter of scattered radiation received on said detection arrangement; and employ a respective different readout scheme for each said regions of interest, so as to read out said detection arrangement.

The above and other aspects of the invention will be understood from a consideration of the examples described below.

BRIEF DESCRIPTION OF THE DRAWINGS

Embodiments will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 depicts a schematic representation of a metrology apparatus in which EUV and/or SXR radiation is used;
- Figure 6 depicts a simplified schematic drawing of an illumination source, which may be the illumination source for high harmonic generation for a metrology apparatus such as that illustrated in Figure 5;
- Figure 7 comprises (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 8 is a schematic illustration of a metrology apparatus of known configuration;
- Figure 9 is an illustration of a 2D diffraction pattern as may be obtained using a metrology apparatus such as illustrated in Figure 8;
- Figure 10(a) shows the 2D diffraction pattern of Figure 9 and Figure 10(b) illustrates how such a pattern may be divided into two regions of interest according to an embodiment;
- Figure 11 illustrates a function of total acquisition time against a threshold value for dividing incident power into two regions of interest; and
- Figure 12 comprises timing diagrams for (a) a conventional rolling shutter readout scheme (b) an example readout schemes according to a first embodiment, and (c) an example readout schemes according to a second embodiment.

DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

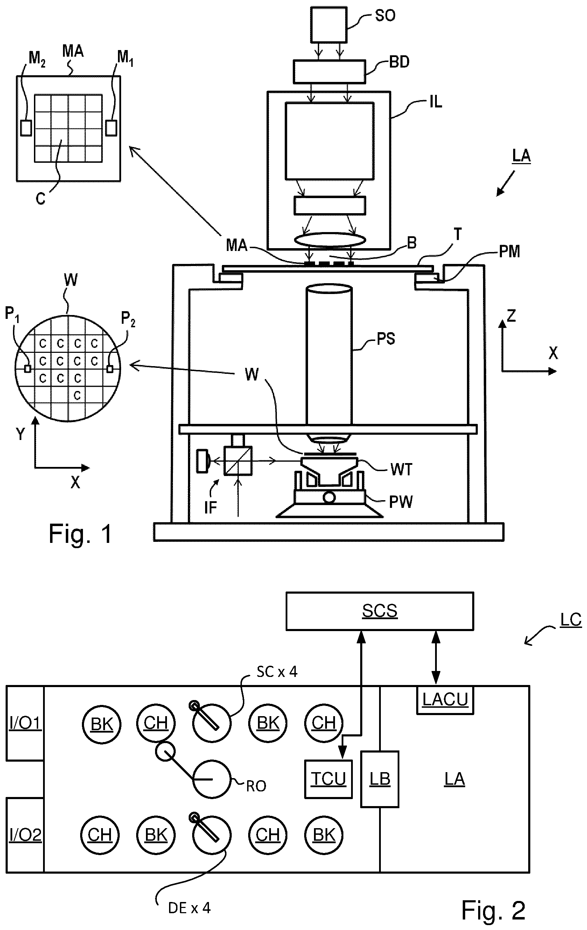

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR) soft X-ray (SXR), extreme ultraviolet (EUV), visible to near-IR and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered, which may be diffracted, reflected or transmitted, radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

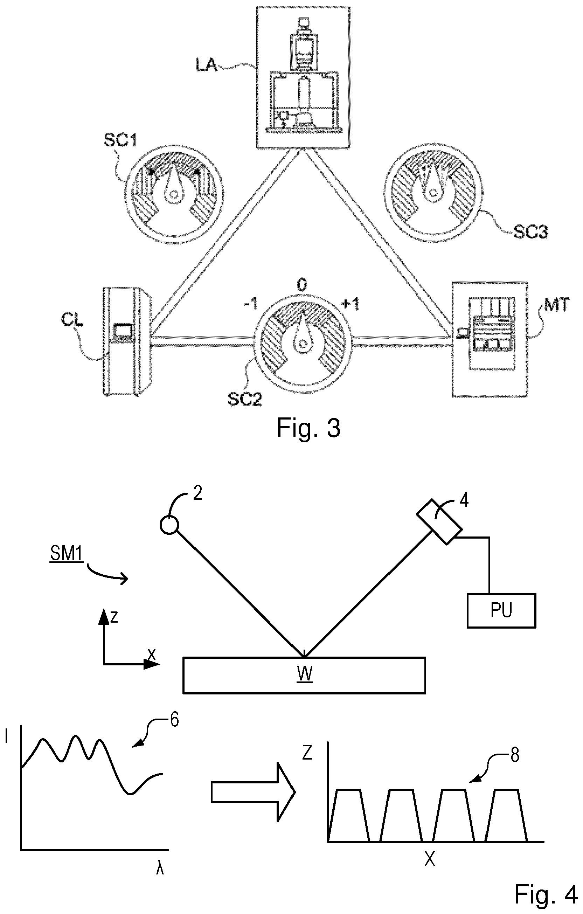

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system) e.g., running a computer program. The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from multiple gratings using light from soft x-ray, extreme ultraviolet and visible to near-IR wave range.

One example of metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is another example. The transmitted radiation is passed to a spectrometer detector, which measures a spectrum as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling and x-ray mathematical model and an optical mathematical model through one or more common. The contents of the cited US patent applications are incorporated herein by reference in their entirety.

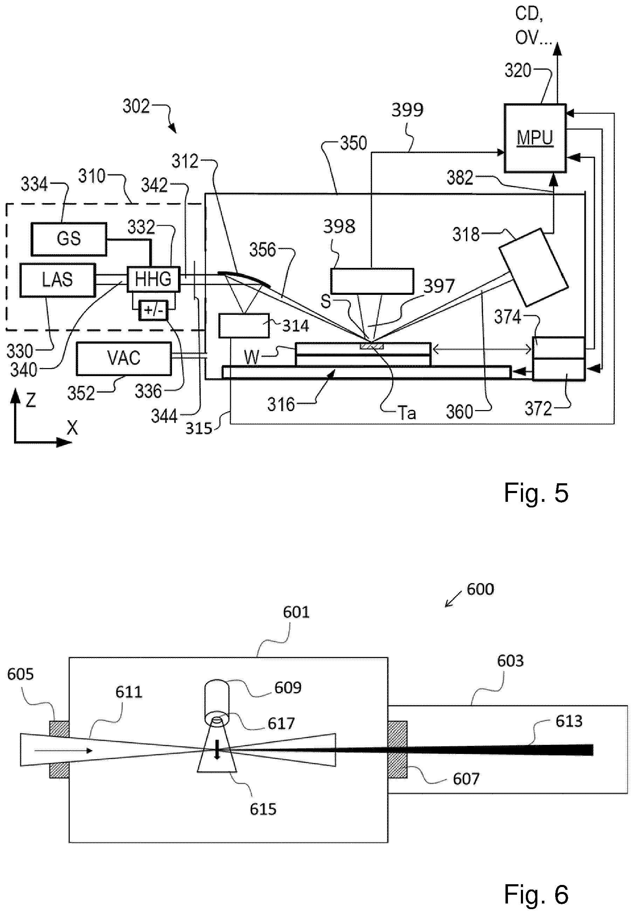

Figure 5 depicts a schematic representation of a metrology apparatus 302 in which the aforementioned radiation may be used to measure parameters of structures on a substrate. The metrology apparatus 302 presented in Figure 5 may be suitable for the hard X-ray, the soft X-rays and/or EUV domain.

Figure 5 illustrates a schematic physical arrangement of a metrology apparatus 302 comprising a spectroscopic scatterometer using hard X-ray, EUV and/or SXR radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10$\mu$m, for example in the region of 1 $\mu$m (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume.

The gas may be for example air, Neon (Ne), Helium (He), Nitrogen ($N_2$), Oxygen ($O_2$), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 $\mu$m in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 5, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 5 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths a range from 0.01 nm to 100 nm, optionally from 0.1 nm to 100 nm, optionally from 1 nm to 100 nm, optionally from 1 nm to 50 nm, or optionally from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. A source may use High Harmonic Generation (HHG) or any other types of illumination sources mentioned above to obtain radiation at the desired wavelength(s). One of the challenges faced in the development of these sources is how to couple the emitted radiation out of the generating setup efficiently and separate the emitted radiation from the radiation used to drive the process.

Figure 6 shows a simplified schematic drawing of an embodiment 600 of an illumination source 310, which may be the illumination source for high harmonic generation. One or more of the features of the illumination source in the metrology tool described with respect to Figures 5 may also be present in the illumination source 600 as appropriate. The illumination source 600 comprises a chamber 601. The illumination source 600 is configured to receive a pump radiation 611 with a propagation direction which is indicated by an arrow. The pump radiation 611 shown here is an example of the pump radiation 340 from the pump radiation source 330, as shown in Figure 5. The pump radiation 611 may be directed into the chamber 601 through the radiation input 605, which maybe a viewport which may be made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen ($N_2$), Oxygen ($O_2$), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system comprises a gas nozzle 609, as shown in Figure 6, which may comprise an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 5. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607, e.g. an aperture or window, and may be subsequently manipulated and directed by an illumination system 603, which may be an example of the illumination system 312 in Figure 5, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUVSXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUVSXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 6 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

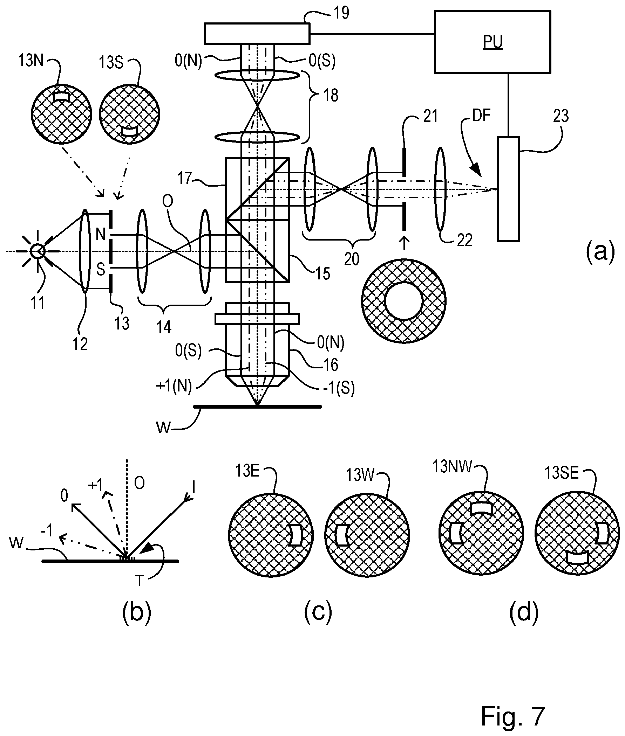

A further metrology apparatus suitable for use in embodiments of the invention is shown in Figure 7(a). Note that this is only one example of a suitable metrology apparatus. An alternative suitable metrology apparatus may use EUV radiation such as, for example, that disclosed in WO2017/186483A1. A target structure T and diffracted rays of measurement radiation used to illuminate the target structure are illustrated in more detail in Figure 7(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 7(b), target structure T is placed with substrate W normal to the optical axis O of objective lens 16. The substrate W may be supported by a support (not shown). A ray of measurement radiation I (e.g., comprising SXR wavelengths) impinging on target structure T from an angle off the axis O gives rise to a zeroth order ray (solid line 0) and two first order rays (dot-chain line +1 and double dot-chain line -1). It should be remembered that with an overfilled small target structure, these rays are just one of many parallel rays covering the area of the substrate including metrology target structure T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the target structures and the illumination angles can be designed or adjusted so that the first order rays entering the objective lens are closely aligned with the central optical axis. The rays illustrated in Figure 7(a) and 7(b) are shown somewhat off axis, purely to enable them to be more easily distinguished in the diagram.

At least the 0 and +1 orders diffracted by the target structure T on substrate W are collected by objective lens 16 and directed back through beam splitter 15. Returning to Figure 7(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target structure on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target structure T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

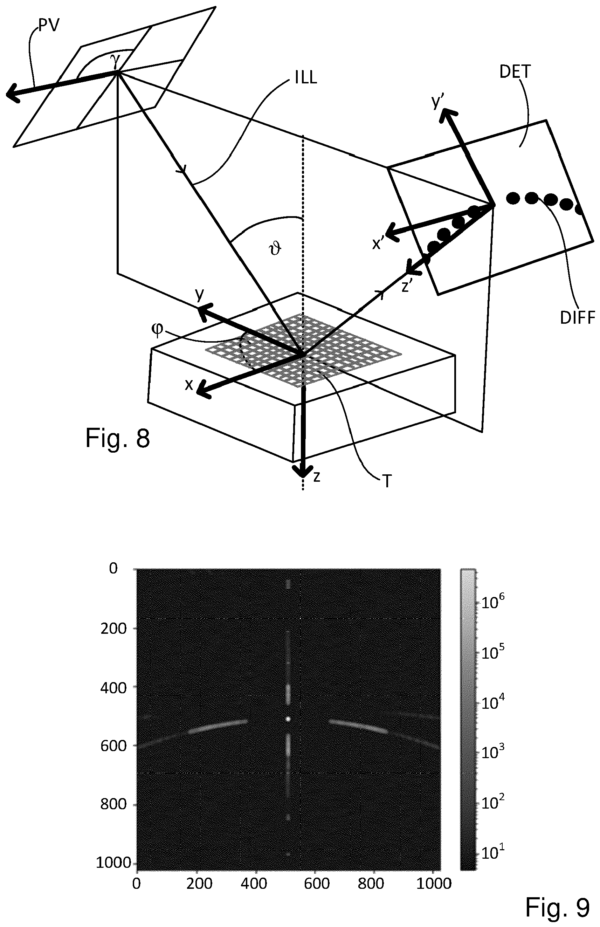

Figure 8 is a schematic drawing of an example measurement using an SXR metrology device such as illustrated in Figure 5. In SXR metrology, a beam of SXR radiation ILL (e.g., in the 10-20 nm wavelength range) may be used to illuminate a structure or target T (in a structure plane or target plane). The diffraction pattern DIFF is captured by (at least one) detector DET, which may be an image sensor, for example a CCD or CMOS image sensor. The target T coordinate system is labelled x, y, z (where x and y describe the structure plane/target plane) and the detector coordinate system is labelled x', y', z'. The illumination angle of incidence is labelled $\vartheta$, the illumination azimuth angle is labelled $\varphi$. The illumination polarization vector PV has a polarization angle $\chi$. The detector DET may in fact be a detection arrangement comprising two or more detectors which are not necessarily co-planar. As such, the method relates to any detection arrangement which may include a single detector or more than one detectors. Any mention of detector herein may be expanded to, and understood to mean, a detection arrangement. Such a detection arrangement may be part of a detection module of a metrology device, the detection module further comprising a processor.

Figure 9 is an example 2D diffraction image as may be captured on detector DET or detection arrangement (which may comprise one or multiple individual detectors) comprising a detection area defining a pixel array (i.e., the detection arrangement defines a detection area in terms of a plurality of pixels). In this specific example, the x and y axes are labeled in terms of pixels (e.g., a 1024x1024 pixel detector). The detector specifics are of course purely an example. As can be seen, a number of the diffraction orders comprise curved lines, with a curvature dependent on orientation and position of the detector DET as well as the angles of incidence of the incoming beam on the inspection target.

The larger the angular space that is captured by the detector(s) (the detection NA), the better for measurement accuracy and the shorter the product pitches that are supported by the metrology setup. Due to the nature of the high brightness source (high intensity in a small divergent beam), the detector is very unevenly illuminated. The diffraction orders are high intensity spots on the detector, but most of the detector is not illuminated. This is immediately apparent from Figure 9. However, a spread in the positions of all the diffraction orders is large, and hence a large detection area is needed to capture them all (large detection NA). As a result, the few pixels on the detector that are illuminated quickly saturate in an otherwise empty image. To capture enough light for an accurate single measurement, several frames have to be taken in order not to saturate those limited number of illuminated pixels. In this context, a frame may be an individual image capture. In one embodiment, the signal to be detected is processed frame-by-frame in nonoverlapping intervals. In one embodiment, the signal to be detected is processed frame-by-frame in overlapping intervals.

Reading out those frames from the camera takes time, for example it can take over 150ms to perform a 14 bit readout with current detectors. Present detector technology optionally enables performing a rolling shutter operation. In such a rolling shutter operation, the photons incident on the detector are recorded/detected in parallel with the readout of an immediately preceding frame. This is particularly useful when an exposure time Te for a single frame is similar to a readout time Tf for that frame, as it means that the total time needed for a single frame will then not exceed a maximum of exposure time and readout time (i.e., max(Te,Tf)), instead of a sum of these durations (i.e., Te+Tf).

The exposure time required to saturate a single frame depends on the source power and source divergence, transmission and magnification of the optical system, detector configuration and the diffraction efficiency of the target. The latter is a fraction which indicates how much of the light incident on a target is in a certain diffraction order. The detector configuration describes the size of the pixels, electron well depth per pixel, distance between the detector and the target and their mutual orientation, all of which influence how many photons it takes to saturate a pixel.

Until recently, source power was relatively low, causing the exposure time to be significantly longer than the readout time of the detector. However, source power is increasing, meaning that exposure time is expected to decrease such that readout time of the detector will become the limiting factor, rather than the exposure time. A result of this may be to put an absolute minimum limit on the total acquisition times achievable with SXR metrology e.g., of about 5-20 seconds, thereby rendering the acquisition time insensitive to any further source development.

Presently, the whole frame (all detection pixels) is read out because, particularly in the case of 2D target gratings, the scattered radiation or diffraction orders are scattered all over the detector (e.g., having been scattered by a structure such as a target on a substrate). However, detector readout time depends on how many rows (or individual pixels, if the detector allows) are read out. There are typically significantly fewer rows comprising bright pixels (e.g., illumination from diffraction orders) than rows comprising comparatively dark pixels. The rows (or at least some of them) comprising darker pixels may still need to be read out, as they contain information, but not necessarily at the frame rate dictated by the brightest pixels/rows.

It is therefore proposed to apply different acquisition modes to different areas or regions of the detector (e.g., different regions of interest ROI). In this context, each different region of interest is not necessarily contiguous (i.e., a "region of interest" may comprise a plurality of separated regions/areas on the detector or detectors) although one or more regions may be contiguous. In an embodiment, the different regions of interest may be non-overlapping, e.g., such that each pixel is allocated to only one of the regions of interest. A frame for each ROI may comprise an individual image capture for the respective ROI.

The division of the detection area into ROIs, each having a respective acquisition mode, may be determined based on the intensity distribution over the detector. The detector may switch quickly between the acquisition modes during a single total acquisition (a single target measurement comprising an exposure period and readout period), such that each ROI is read out individually. Alternatively, the detector may support a parallel exposure and acquisition of the various ROIs.

By way of a specific example, it may be assumed that a certain target requires Nf frames to be read out for a single full acquisition. Each pixel (which may be described in terms of i-th row, j-th column) will have a respective power $P_{ij}$ incident thereon. It can be appreciated that, while the description will describe incident signal magnitude on the detector in terms of power, any other measurement parameter related to the intensity or amplitude of the incident radiation may be used and power may be replaced (consistently) by any such other measurement parameter throughout the description. There is one pixel (i,j)=(m,n) that has a highest incident power $P_{max}$. To avoid saturation, the exposure time Te for that pixel (m,n) (and therefore the full frame using conventional methods) is inversely proportional to the highest incident power Pmax; i.e., Te=Dsat/Pmax, with proportionality constant Dsat describing a saturation dose for the pixel. Dsat is a property of the detector and is largely proportional to a surface area of a single pixel and its full well capacity. The total acquisition time $TAT_c$ for a conventional readout scheme (taking into account the rolling shutter method already described) is then:

$TAT_c$ = Nf*max(Te,Tf); where Tf is a readout time per frame.

In an example where a rolling shutter is not used, the total acquisition time will be the product of the number of frames to be read out and the sum of the exposure time and readout time per frame.

The proposed method may comprise defining at least one threshold measurement parameter value for use as a threshold for comparison to the measured pixel measurement parameters, such that they can be categorized into different ROIs, in terms of the measurement parameter incident on the detector, based on the comparison. The at least one threshold measurement parameter value may be defined in terms of a respective threshold fraction Td of the maximum detected measurement parameter value. For example, a threshold fraction may comprise a value between 0 and 1 which, in combination with a detected maximum measurement parameter value, determines the threshold measurement parameter value or cut-off measurement parameter value to which all measured pixel measurement parameter values may be compared. The threshold measurement parameter value may for example be calculated as a product of the threshold fraction and the detected maximum measurement parameter value

Using the specific example described, a threshold power Ptd may be determined from a detected power maximum Pmax and the threshold fraction Td; e.g., as the product of the detected power maximum: Ptd=Td*Pmax. All pixels with a respective power Pij greater than the threshold power Ptd (i.e., Pij>Ptd) may be attributed to a first ROI, and the remaining pixels (i.e., those with a respective power Pij less than or equal to the threshold power Ptd (i.e., Pij≤Ptd)) may be attributed to a second ROI. However, a per-pixel allocation such as this is not always possible, as will be described below.

It can be appreciated that more than two ROIs may be defined by setting two or more threshold measurement parameter values (e.g., as respective different fractions of the maximum detected values), with each of the ROIs having a respective different acquisition mode. Such embodiments are not described in detail, but will be apparent to the skilled person. For example, a first ROI may be defined for pixel powers in a lower range, a second ROI for pixel powers in an intermediate range and a third ROI for pixel powers in a higher range. Each of these may then be read out using a respective different acquisition mode such as described below, or it may be chosen not to read out a specific ROI at all.

Many detectors have only individual readout control per a subset > 1 of detector pixels, such as a per-row (or per-column) readout. In such a case, any decision whether to readout portions of the detector can only be made at the subset or row/column level rather than the pixel level. As such, it may be that ROIs may be defined only in terms of rows, columns or subsets rather than pixels, wherein a subset represents a smallest unit of said detection area which can be individually read out. However, the concepts disclosed herein are also applicable to detector arrangements which support per-pixel level control (i.e., wherein each pixel can be individually read out) and as such the ROIs may be defined per pixel for additional improvement.

In the example of row level control in the context described above, the first ROI may comprise all rows for which there exists a respective power value Pij greater than threshold power Ptd and the second ROI may comprise all rows for which there are no respective power values Pij greater than threshold power Ptd. In such an example, the first ROI may be assigned a first ROI exposure time Te1, e.g., the exposure time which can be expected to saturate the first ROI. This may be the exposure time Te of the pixel m,n subject to the largest incident power (i.e., the same exposure time as for the entire detector in a conventional scheme). However, a longer exposure time may be assigned to the second ROI, as it will take longer for these rows (or pixels) to saturate. This longer exposure time Te2 may be based on the threshold and exposure time Te, for example it may be calculated as Te2=Te/Td. Where more than two ROIs are defined, each may have an associated different exposure time, e.g., as defined by each ROI's respective threshold value. As such, a pixel or subset of pixels may be allocated to a region of interest associated with a corresponding readout scheme having a shortest readout period of the readout schemes if said pixel or a pixel of said subset of pixels has an associated measurement parameter value greater than said threshold measurement parameter value.

As such, for a given threshold fraction Td (e.g., in a two ROI example with per-row readout control), there will be a number N1 of rows in in the first ROI and a number N2 of rows in the second ROI. Each row (or pixel) may have an associated readout time Trow, e.g., which may be dependent on the analog-to-digital converter (ADC) resolution; additionally there may be a constant readout time contribution per ROI. The respective readout times Tf1, Tf2 of the first ROI and second ROI can therefore be calculated separately. The number of frames Nf1 requiring readout for the first ROI may be the same as for a conventional readout scheme i.e., Nf frames as described above. However, a number of frames Nf2 to be readout for the second ROI may be less than Nf; e.g., by a factor dependent on the threshold fraction. For example, the number of frames Nf2 may be determined by: Nf2=ceil(Td*Nf), where ceil is a ceiling function indicating rounding-up to the nearest whole integer as only integer number of frames can be read out.

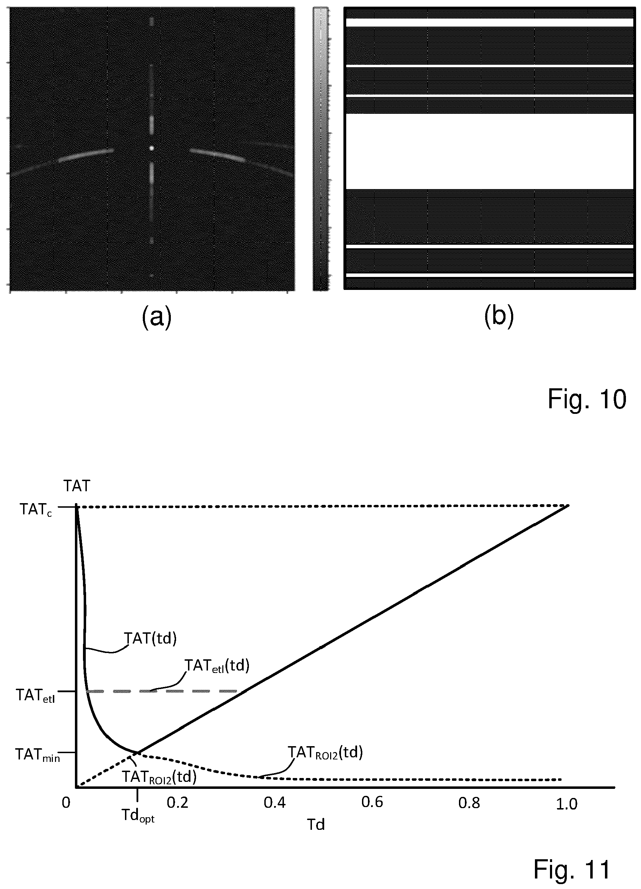

Figure 10 illustrates how the detected image of Figure 9 may be divided into two ROIs. Figure 10(a) is the detected image and Figure 10(b) shows the image divided into white colored rows and black colored rows. The white colored rows together define the first ROI (i.e., those rows comprising at least one pixel having an incident power above a threshold value determined as described) and the black colored rows define the second ROI (i.e., those rows comprising no pixels having an incident power above the threshold value).

In embodiments which employ a rolling shutter, such that a frame can be exposed in parallel to read-out of the previous frame, the total acquisition time may now be a maximum of a respective ROI total acquisition time for the first ROI and second ROI, where the exposure and readout time of a single frame for each respective ROI is the maximum of the exposure time and readout time for that ROI (or the sum in embodiments without a rolling shutter). As such, the total acquisition time TAT for a proposed method according to an embodiment may be given by:

$$TAT = \max(Nf*\max(Te1,Tf1), ceil(Td*Nf)*\max(Te2/Td,Tf2))$$

The parameters Nf, Te1 depend on the original detector and target configuration. The optimal choice for the other parameters depends on the choice of threshold fraction Td, which may be optimized per target and thus is a tuning parameter. Setting the threshold fraction Td at or close to 1 or 0 is essentially a conventional readout scheme. An optimal intermediate value may be found such that total acquisition time TAT is significantly lower than using the total acquisition time $TAT_c$ for the conventional method.

It can be appreciated that this equation for TAT is purely an example, and for example may be more complex in certain situations. This may be the case, for example, when there is a constant contribution to the readout time which is independent of the number of rows/pixels per ROI. Moreover, to have the (semi)parallel readout work smoothly in a rolling shutter model, the readout frequencies may be matched such that, for example, one readout time is an integer multiple of the other readout time. Such a constraint would also modify the TAT equation.

Figure 11 is a plot of total acquisition time TAT against threshold fraction Td for an example intensity distribution on a detector, illustrating how the threshold fraction Td may be optimized according to an embodiment. Such a method may comprise determining a function TAT(Td) (solid black line) and determining an optimized threshold fraction $Td_{opt}$ as that corresponding to a minimum $TAT_{min}$ of this function TAT(Td). It can be seen that this minimum total acquisition time $TAT_{min}$ is much shorter than the total acquisition time $TAT_c$ for a conventional method. The function TAT(Td) may be determined as a combination of the respective portions of the total acquisition time as a function of threshold fraction for the first ROI $TAT_{ROI1}$(Td) and for the second ROI $TAT_{ROI2}$(Td) which are above the minimum $TAT_{min}$ (e.g., above their intersection point). The portions of these functions below the minimum are shown as dotted lines to illustrate this. As such, the method may comprise determining said threshold fraction as that corresponding to an intersection point of a first region of interest function describing a total acquisition time for a first region of interest as a function of threshold fraction and a second region of interest function describing a total acquisition time for a second region of interest as a function of threshold fraction.

It is possible, e.g., depending on hardware characteristics, that the exposure time limits the minimum total acquisition time at an exposure limited total acquisition time $TAT_{etl}$. This is illustrated by the gray dashed line, resulting in an exposure time limited total acquisition time function $TAT_{etl}$(td) comprising the portions of functions $TAT_{ROI1}$(Td), $TAT_{ROI2}$(Td) only above this value $TAT_{etl}$ such that the function does not fall below $TAT_{etl}$. In such an embodiment, any threshold fraction Td for which the exposure time limited total acquisition time function $TAT_{etl}$(td) is at a minimum will be optimal and there will be no difference in the total exposure time between any of the values within this threshold fraction range. In any case, as source power increases, $TAT_{etl}$ will decrease in value and the exposure time will have less of an impact.

In an embodiment, this threshold optimization may be performed for each target and/or stack, as it is target/stack dependent. The ROI definitions are subsequently to be set in the detector software. However, this only needs to be done once per target (e.g., in a calibration) and therefore does not impose any significant overhead.

As has already been described, the above method can be expanded to more than two ROIs, ROI that are defined not per row but per pixel (2D-ROI). Furthermore, in an optional embodiment, it can be decided to not read out one of the defined ROIs, for example because a low-threshold of pixel power or other measurement parameter is not exceeded and thus the pixel does not contain significant information. Not reading out an ROI is employing a readout scheme (i.e., not reading out is itself a readout scheme) within the context of this disclosure.

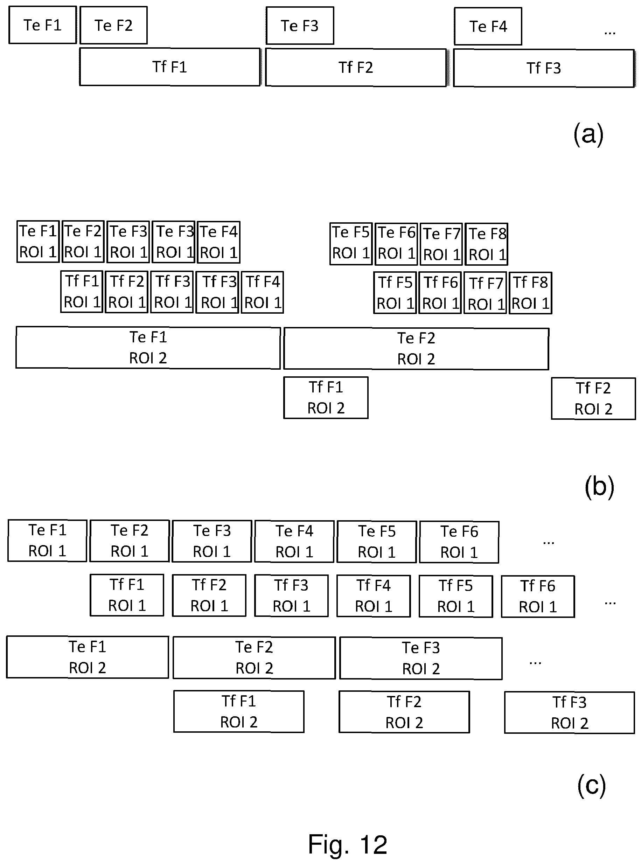

Figure 12 illustrates (a) a conventional rolling shutter readout scheme and (b), (c) two example readout schemes according to methods disclosed herein. Each Figure is a timing diagram with the time extending left to right.

In Figure 12(a) illustrates a conventional rolling shutter readout scheme where a first frame is exposed during an initial time period TeF1, followed by, in parallel, exposure of a second frame TeF2 and readout of the first frame TfF1. Once both of these are complete (i.e., as dictated by the longer of the exposure time and readout time), this can be repeated for the next frame (i.e., exposure of a third frame TeF3 and readout of the second frame TfF2), and so on.

Figure 12(b) illustrates a readout scheme implementation for an embodiment where two ROIs are defined as has been described. This arrangement may be suitable for a hardware/firmware arrangement which does not support full parallel readout (as may be the case). In this arrangement, there are separate readout sub-schemes for the first ROI, ROI 1, and second ROI, ROI2. Each of these readout sub-schemes essentially follows the same or similar rolling shutter scheme as that illustrated in Figure 12(a), although with a longer exposure time Te ROI 2 (and optionally longer readout time Tf ROI 2) for the second ROI than for the first ROI (Te ROI 1, Tf ROI 1). However, in the absence for support of a full parallel implementation, the fast readout/framerate of ROI 1 is temporarily stopped to read-out ROI 2. This may be because, for example, the same ADC is used to readout both ROIs. The additional total acquisition time over the fully parallelized scheme (i.e., in addition to the time TAT according to the equation above) is ceil(Td*Nf)*Tf2.

Figure 12(c) illustrates a readout scheme implementation which is similar to that illustrated in Figure 12(b), but with a fully parallel implementation. This may be implemented by providing an ADC per ROI. It is in this implementation that the total acquisition time TAT is that recited in the equation above.

To provide for a rolling shutter readout with multiple ROIs, the detector firmware may be provided with a mechanism for controlling which readout mode to perform at a given moment, and a mechanism to switch rapidly between those modes. This could be provided, for example, in a synchronized digital TTL (transistor-transistor logic) line and a trigger for detector readout start. A more efficient implementation may comprise providing a proposed readout scheme to the detector firmware, such that the firmware runs a desired scheme based on an input vector or row numbers representing the definition of its respective ROI. This would also benefit start-up of an acquisition sequence, as a frame 0 will comprise all radiation from before the start of the readout, and therefore can be read out so as to zero the detector. As such, for multiple ROIs and readout modes, this results in at least one round of all the ROIs being read out before any detected radiation is due to the measurement (i.e., it is only background radiation). Running the scheme via the detector and ignoring undesired frames (for example during moves between two targets) may be more efficient than starting and stopping the acquisition scheme.

Further embodiments are disclosed in the subsequent numbered clauses:

1. A method of reading out a detection arrangement, said detection arrangement defining a detection area in terms of plurality of pixels, the method comprising:

receiving scattered radiation on said detection arrangement;
dividing said detection area into at least two different regions of interest based at least on a measurement parameter of said scattered radiation; and
employing a respective different readout scheme for each said regions of interest, so as to read out said detection arrangement.

2. A method as claimed in clause 1, wherein read out of at least one of said regions of interest is performed over a plurality of frames of the respective region of interest.

3. A method as claimed in clause 2, wherein said readout schemes differ at least in terms of an exposure time/and or a readout time of each frame.

4. A method as claimed in clause 2 or 3, wherein, for each region of interest, exposure of a present frame is performed in parallel with readout of an immediately preceding frame, for at least some of said plurality of frames.

5. A method as claimed in any preceding clause, wherein each region of interest is defined in terms of one or more individual pixels, wherein each pixel can be individually read out.

6. A method as claimed in any of clauses 1 to 4, wherein each region of interest is defined in terms of one or more subsets of pixels, wherein said subsets represent a smallest unit of said detection area which can be individually read out.

7. A method as claimed in clause 6, wherein each subset comprises an individual row or column of pixels.

8. A method as claimed in any preceding clause, wherein said dividing step comprises:

determining at least one threshold measurement parameter value; and
comparing a measurement parameter of each pixel to said at least one threshold measurement parameter value.

9. A method as claimed in clause 8, comprising allocating a pixel or subset of pixels to one of said regions of interest based on said comparison step.

10. A method as claimed in clause 9, wherein said allocating step comprising allocating said pixel or subset of pixels to a region of interest associated with a corresponding readout scheme having a shortest readout period of the readout schemes if said pixel or a pixel of said subset of pixels has an associated measurement parameter value greater than said threshold measurement parameter value.

11. A method as claimed in any of clauses 8 to 10, wherein said step of determining at least one threshold measurement parameter value comprises:

determining a maximum measurement parameter value incident on said detection arrangement;

determining at least one threshold fraction; and

determining said at least one threshold measurement parameter value as a combination of said maximum measurement parameter value and a respective threshold fraction of said at least one threshold fraction.

12. A method as claimed in clause 11, comprising determining said at least one threshold fraction as that corresponding to a minimum total acquisition time for a function describing total acquisition time for a measurement as a function of threshold fraction.

13. A method as claimed in clause 12, wherein said minimum total acquisition time is limited by an exposure time of a frame of an acquisition.

14. A method as claimed in clause 11, 12 or 13, comprising determining said threshold fraction as that corresponding to an intersection point of a first region of interest function describing a total acquisition time for a first region of interest of said at least two different regions of interest as a function of threshold fraction and a second region of interest function describing a total acquisition time for a second region of interest of said at least two different regions of interest as a function of threshold fraction.

15. A method as claimed in any preceding clause, wherein there is no overlap between respective regions of interest of said at least two regions of interest.

16. A method as claimed in any preceding clause, wherein one of said readout schemes comprises not reading out its respective region of interest.

17. A method as claimed in any preceding clause, wherein said regions of interest number two.

18. A method as claimed in any of clauses 1 to 16, wherein said regions of interest number more than two.

19. A method as claimed in any preceding clause, wherein the regions of interest are read out in parallel.

20. A method as claimed in any of clauses 1 to 18, wherein the regions of interest are read out individually.

21. A method as claimed in any preceding clause, wherein a total acquisition time for an acquisition is a maximum of a respective region of interest total acquisition time for each of said regions of interest.

22. A method as claimed in any preceding clause, wherein said scattered radiation comprises photons and/or electrons.

23. A method as claimed in any preceding clause, wherein said scattered radiation has been scattered by a structure on a substrate.

24. A method as claimed in any preceding clause, wherein said measurement parameter comprises an intensity, amplitude or power of said scattered radiation.

25. A method as claimed in any preceding clause, wherein read out frequencies for each respective different readout scheme are matched such that the read out frequencies all comprise integer multiples of each other.

26. A computer program comprising computer readable instruction operable to perform the method of any of clauses 1 to 25.

27. A processor and associated storage medium, said storage medium comprising the computer program of clause 26 such that said processor is operable to perform the method of any of clauses 1 to 25.

28. A metrology device comprising the processor and associated storage medium of clause 21 so as to be operable to perform the method of any of clauses 1 to 27.

29. A detection module, comprising:

a detection arrangement defining a detection area in terms of plurality of pixels; and
a processor operable to:

divide said detection area into at least two different regions of interest based at least on a measurement parameter of scattered radiation received on said detection arrangement; and
employ a respective different readout scheme for each said regions of interest, so as to read out said detection arrangement.

30. A detection module as claimed in clause 29, wherein the processor is operable to read out at least one of said regions of interest over a plurality of frames of the respective region of interest.

31. A detection module as claimed in clause 30, wherein said readout schemes differ at least in terms of an exposure time/and or a readout time of each frame.

32. A detection module as claimed in clause 30 or 31, wherein the processor is operable, for each region of interest, to expose a present frame in parallel with readout of an immediately preceding frame for at least some of said plurality of frames.

33. A detection module as claimed in any of clauses 29 to 32, wherein the processor is operable to define each region of interest in terms of one or more individual pixels, wherein each pixel can be individually read out.

34. A detection module as claimed in any of clauses 1 to 32, wherein the processor is operable to define each region of interest in terms of one or more subsets of pixels, wherein said subsets represent a smallest unit of said detection area which can be individually read out.

35. A detection module as claimed in clause 34, wherein each subset comprises an individual row or column of pixels.

36. A detection module as claimed in any of clauses 29 to 35, wherein said processor is operable to perform said dividing by:

determining at least one threshold measurement parameter value; and
comparing a measurement parameter of each pixel to said at least one threshold measurement parameter value.

37. A detection module as claimed in clause 36, wherein the processor is operable to allocate a pixel or subset of pixels to one of said regions of interest based on said comparison step.

38. A detection module as claimed in clause 37, wherein the processor is operable to allocate said pixel or subset of pixels to a region of interest associated with a corresponding readout scheme having a shortest readout period of the readout schemes if said pixel or a pixel of said subset of pixels has an associated measurement parameter value greater than said threshold measurement parameter value.

39. A detection module as claimed in any of clauses 36 to 38, wherein the processor is operable to determine at least one threshold measurement parameter value by:

determining a maximum measurement parameter value incident on said detection arrangement;
determining at least one threshold fraction; and
determining said at least one threshold measurement parameter value as a combination of said maximum measurement parameter value and a respective threshold fraction of said at least one threshold fraction.

40. A detection module as claimed in clause 39, comprising wherein the processor is operable to determine said at least one threshold fraction as that corresponding to a minimum total acquisition time for a function describing total acquisition time for a measurement as a function of threshold fraction.

41. A detection module as claimed in clause 40, wherein said minimum total acquisition time is limited by an exposure time of a frame of an acquisition.

42. A detection module as claimed in clause 39, 40 or 41, wherein the processor is operable to determine said threshold fraction as that corresponding to an intersection point of a first region of interest function describing a total acquisition time for a first region of interest of said at least two different regions of interest as a function of threshold fraction and a second region of interest function describing a total acquisition time for a second region of interest of said at least two different regions of interest as a function of threshold fraction.

43. A detection module as claimed in any of clauses 29 to 42, wherein there is no overlap between respective regions of interest of said at least two regions of interest.

44. A detection module as claimed in any of clauses 29 to 43, wherein one of said readout schemes comprises not reading out its respective region of interest.

45. A detection module as claimed in any of clauses 29 to 44, wherein said regions of interest number two.

46. A detection module as claimed in any of clauses 1 to 44, wherein said regions of interest number more than two.

47. A detection module as claimed in any of clauses 29 to 46, operable such that the regions of interest are read out in parallel.

48. A detection module as claimed in clause 47, wherein the detection arrangement comprises a respective analogue to digital converter for each of said regions of interest.

49. A detection module as claimed in any of clauses 1 to 46, wherein the regions of interest are read out individually.

50. A detection module as claimed in clause 49, wherein the detection arrangement comprises a shared analogue to digital converter for each of said regions of interest.

51. A detection module as claimed in any of clauses 29 to 50, wherein the processor is operable to determine a total acquisition time for an acquisition as a maximum of a respective region of interest total acquisition time for each of said regions of interest.

52. A detection module as claimed in any of clauses 29 to 51, wherein said scattered radiation comprises photons and/or electrons.

53. A detection module as claimed in any of clauses 29 to 52, wherein said scattered radiation has been scattered by a structure on a substrate.

54. A detection module as claimed in any of clauses 29 to 53, wherein said measurement parameter comprises an intensity, amplitude or power of said scattered radiation.

55. A detection module as claimed in any of clauses 29 to 54, wherein the processor is operable such that read out frequencies for each respective different readout scheme are matched such that the read out frequencies all comprise integer multiples of each other.

56. A metrology device comprising a detection module as claimed in any of clauses 29 to 55.

While the above methods have been disclosed in the context of SXR metrology, the methods are not limited to metrology using any particular wavelengths or wavelength ranges, and as such may equally be used in metrology methods at visible and/or any other wavelengths. The metrology device may be an electron microscopy device, rather than using electromagnetic radiation, and therefore any mention of scattered radiation or measurement radiation may be understood to include photons and/or electrons.

Although specific reference may be made in this text to the detection arrangement of a metrology device, it should be understood that the detection arrangement described herein may be part of a lithographic apparatus or an inspection apparatus. One example of the inspection apparatus with the above-mentioned embodiments is a charged particle (e.g., electron) beam microscope, such as a scanning electron microscope (SEM) or a transmission electron microscope (TEM).

The methods described herein may be embodied in the form of a computer program comprising computer readable instruction.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, includes radio waves, microwaves, infrared, (visible) light, ultraviolet, X-rays, and gamma rays.

While specific embodiments have been described above, it will be appreciated that one or more of the features in one embodiment may also be present in a different embodiment and that features in two or more different embodiments may also be combined.

**Claims**

1. A method of reading out a detection arrangement, said detection arrangement defining a detection area in terms of plurality of pixels, the method comprising:

   receiving scattered radiation on said detection arrangement;
   dividing said detection area into at least two different regions of interest based at least on a measurement parameter of said scattered radiation; and
   employing a respective different readout scheme for each said regions of interest, so as to read out said detection arrangement.

2. A method as claimed in claim 1, wherein read out of at least one of said regions of interest is performed over a plurality of frames of the respective region of interest.

3. A method as claimed in claim 2, wherein said readout schemes differ at least in terms of an exposure time/and or a readout time of each frame.

4. A method as claimed in claim 2 or 3, wherein, for each region of interest, exposure of a present frame is performed in parallel with readout of an immediately preceding frame, for at least some of said plurality of frames.

5. A method as claimed in any preceding claim, wherein each region of interest is defined in terms of one or more individual pixels, wherein each pixel can be individually read out.

6. A method as claimed in any of claims 1 to 4, wherein each region of interest is defined in terms of one or more subsets of pixels, wherein said subsets represent a smallest unit of said detection area which can be individually read out and wherein optionally each subset comprises an individual row or column of pixels.

7. A method as claimed in any preceding claim, wherein said dividing step comprises:

   determining at least one threshold measurement parameter value; and
   comparing a measurement parameter of each pixel to said at least one threshold measurement parameter value.

8. A method as claimed in claim 7, comprising allocating a pixel or subset of pixels to one of said regions of interest based on said comparison step, and wherein optionally said allocating step comprising allocating said pixel or subset of pixels to a region of interest associated with a corresponding readout scheme having a shortest readout period of the readout schemes if said pixel or a pixel of said subset of pixels has an associated measurement parameter value greater than said threshold measurement parameter value.

9. A method as claimed in any preceding claim, wherein there is no overlap between respective regions of interest of said at least two regions of interest.

10. A method as claimed in any preceding claim, wherein one of said readout schemes comprises not reading out its respective region of interest.

11. A method as claimed in any preceding claim, wherein the regions of interest are read out in parallel.

12. A method as claimed in any of claims 1 to 10, wherein the regions of interest are read out individually.

13. A computer program comprising computer readable instruction operable to perform the method of any of claims 1 to 12.

14. A processor and associated storage medium, said storage medium comprising the computer program of claim 13 such that said processor is operable to perform the method of any of claims 1 to 12.

**15.** A detection module, comprising:

a detection arrangement defining a detection area in terms of plurality of pixels; and
a processor operable to:

divide said detection area into at least two different regions of interest based at least on a measurement parameter of scattered radiation received on said detection arrangement; and
employ a respective different readout scheme for each said regions of interest, so as to read out said detection arrangement.

Fig. 1

Fig. 2

Fig. 3

Fig. 4

Fig. 5

Fig. 6

Fig. 7

Fig. 8

Fig. 9

(a)                                             (b)

Fig. 10

Fig. 11

| Te F1 | Te F2 | | Te F3 | | Te F4 | ... |

| | Tf F1 | Tf F2 | Tf F3 | |

(a)

| Te F1 ROI 1 | Te F2 ROI 1 | Te F3 ROI 1 | Te F3 ROI 1 | Te F4 ROI 1 | | Te F5 ROI 1 | Te F6 ROI 1 | Te F7 ROI 1 | Te F8 ROI 1 |

| | Tf F1 ROI 1 | Tf F2 ROI 1 | Tf F3 ROI 1 | Tf F3 ROI 1 | Tf F4 ROI 1 | | Tf F5 ROI 1 | Tf F6 ROI 1 | Tf F7 ROI 1 | Tf F8 ROI 1 |

| Te F1 ROI 2 | Te F2 ROI 2 |

| | Tf F1 ROI 2 | | Tf F2 ROI 2 |

(b)

| Te F1 ROI 1 | Te F2 ROI 1 | Te F3 ROI 1 | Te F4 ROI 1 | Te F5 ROI 1 | Te F6 ROI 1 | ... |

| | Tf F1 ROI 1 | Tf F2 ROI 1 | Tf F3 ROI 1 | Tf F4 ROI 1 | Tf F5 ROI 1 | Tf F6 ROI 1 | ... |

| Te F1 ROI 2 | Te F2 ROI 2 | Te F3 ROI 2 | ... |

| | Tf F1 ROI 2 | Tf F2 ROI 2 | Tf F3 ROI 2 |

(c)

Fig. 12

Europäisches
Patentamt

European
Patent Office

Office européen
des brevets

# EUROPEAN SEARCH REPORT

Application Number

EP 22 20 0780

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/185199 A1 (SCHNEIDER JR CHARLES ADAMS [US] ET AL) 17 June 2021 (2021-06-17) * paragraph [0107] – paragraph [0131] * * figures 20,27,28 * ----- | 1-15 | INV. G03F7/20 H04N25/443 |
| A | WO 2022/023129 A1 (ASML HOLDING NV [NL]) 3 February 2022 (2022-02-03) * the whole document * ----- | 1,13-15 | |
| A | US 2017/082932 A1 (FU JIYOU [US] ET AL) 23 March 2017 (2017-03-23) * the whole document * ----- | 1,13-15 | |

TECHNICAL FIELDS
SEARCHED (IPC)

G03F
H04N

The present search report has been drawn up for all claims

| Place of search | Date of completion of the search | Examiner |
|---|---|---|
| Munich | 20 March 2023 | Meixner, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 20 0780

This annex lists the patent family members relating to the patent documents cited in the above-mentioned European search report.
The members are as contained in the European Patent Office EDP file on
The European Patent Office is in no way liable for these particulars which are merely given for the purpose of information.

20-03-2023

| Patent document cited in search report | | Publication date | Patent family member(s) | | Publication date |
|---|---|---|---|---|---|
| US 2021185199 | A1 | 17-06-2021 | AU | 2020401544 A1 | 07-07-2022 |
| | | | CA | 3164318 A1 | 17-06-2021 |
| | | | CN | 114902650 A | 12-08-2022 |
| | | | EP | 4074022 A1 | 19-10-2022 |
| | | | JP | 2023506188 A | 15-02-2023 |
| | | | KR | 20220107260 A | 02-08-2022 |
| | | | US | 2021185199 A1 | 17-06-2021 |
| | | | WO | 2021118971 A1 | 17-06-2021 |
| WO 2022023129 | A1 | 03-02-2022 | NONE | | |
| US 2017082932 | A1 | 23-03-2017 | CN | 108027568 A | 11-05-2018 |
| | | | IL | 257866 A | 31-05-2018 |
| | | | JP | 6830492 B2 | 17-02-2021 |
| | | | JP | 2018535560 A | 29-11-2018 |
| | | | KR | 20180045026 A | 03-05-2018 |
| | | | TW | 201721308 A | 16-06-2017 |
| | | | US | 2017082932 A1 | 23-03-2017 |
| | | | WO | 2017053581 A1 | 30-03-2017 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006066855 A1
- US 2011102753 A1
- US 20120044470 A
- US 6952253 B
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B

- US 13033135 B
- US 13533110 B
- US 13891410 B
- WO 2011012624 A
- US 20160161863 A
- US 20160370717 A1
- US 2007224518 A
- US 2019003988 A1
- US 2019215940 A1
- US 20130304424 A1
- US 2014019097 A1, Bakeman
- US 20170184981A1 A
- US 2016282282 A1
- WO 2017186483 A1

**Non-patent literature cited in the description**

- **LEMAILLET et al.** ntercomparison between optical and X-ray scatterometry measurements of FinFET structures. *Proc. of SPIE,* 2013, 8681